# EUROPEAN PATENT SPECIFICATION

(11) **EP 0 301 818 B1**
(45) Date of publication and mention of the grant of the patent: **27.10.1993**
(21) Application number: 88306896.7
(22) Date of filing: 27.07.1988
(51) Int. Cl.: H01S 3/25, H01S 3/19

(54) **Semiconductor laser array device**
Halbleiterlaser-Vielfachanordnung
Réseau laser à semi-conducteur

(30) Priority: 28.07.1987 JP 188279/87
(43) Date of publication of application: 01.02.1989
(73) Proprietor: SHARP KABUSHIKI KAISHA, Osaka 545 (JP)
(72) Inventor: Hosoba, Hiroyuki, Tenri-shi Nara-ken (JP); Matsumoto, Mitsuhiro, Nara-shi Nara-ken (JP); Taneya, Mototaka, Tsukuba-shi Ibaraki-ken (JP); Matsui, Sadayoshi, Tenri-shi Nara-ken (JP); Morimoto, Taiji, Nara-shi Nara-ken (JP)
(74) Representative: Huntingford, David Ian

(56) References cited:
- GB-A- 2 180 096
- JP-A-62 115 795
- PATENT ABSTRACTS OF JAPAN, vol. 10, no. 108 (E-398)[2165], 23rd April 1986 & JP-A-60-245 191
- PATENT ABSTRACTS OF JAPAN, vol. 10, no. 297 (E-444), 9th October 1986 & JP-A-61-113 294

## Description

This invention relates to semiconductor laser array devices with an inner current-confining structure by which current can be injected into the laser oscillation operating area alone of the active layer.

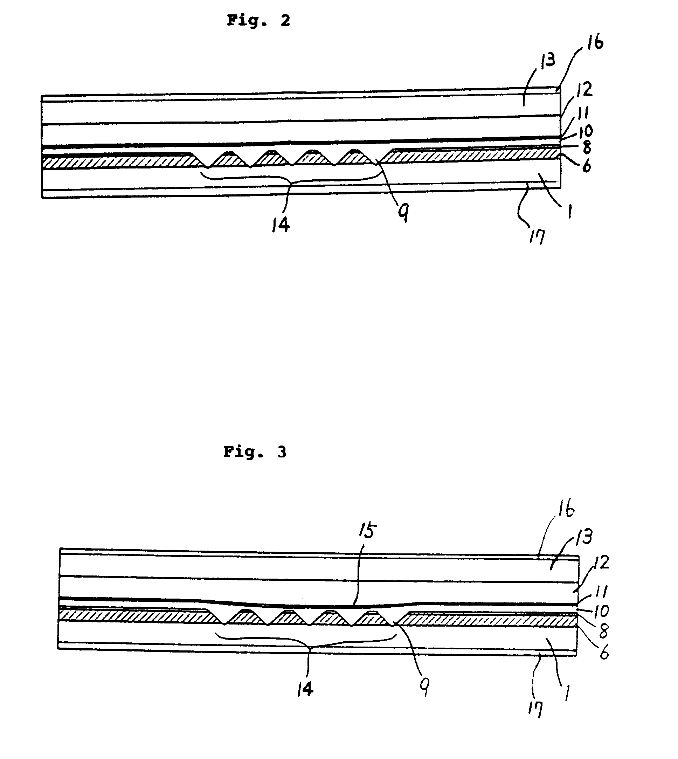

With the advance of semiconductor laser devices that produce high output power, more attention has been paid to semiconductor laser array devices. For the production of semiconductor laser array devices, there are mainly three crystal growth methods, molecular beam epitaxy (MBE), metal-organic chemical vapor deposition (MOCVD), and liquid phase epitaxy (LPE). A semiconductor laser array device that is produced by LPE has been proposed by Matsumoto et al.; Journal of Applied Physics, Vol. 58(7), P. 2783-2785 (1985) in which a V-channelled substrate inner stripe (VSIS) structure with three waveguides is disclosed. Another semiconductor laser array device, having a plurality of lasers integrated in two dimensions for providing a multistripe laser, is disclosed in JP-A-62115795 and Patent Abstracts of Japan, Vol. 11, No. 329 (E-552) [2776], 27th Oct. 1987. Figure 2 shows a semiconductor laser array device with five waveguides, which is produced as follows: on a p-GaAs substrate 1, and n-A1_{0.1}Ga_{0.9}As current blocking layer 6 with a thickness of 0.7µm and an n-GaAs protective layer 8 with a thickness of 0.1µm are successively formed by LPE. Then, five grooves 9 with a width of 4µm each, a depth of 0.9µm each, and a pitch of 5µm are formed by a photolithographic technique and an etching technique in such a way that they reach the p-GaAs substrate 1 through both the n-A1_{0.1}Ga_{0.9}As current blocking layer 6 and the n-GaAs protective layer 8. Then, on the n-GaAs protective layer 8 including the grooves 9, a p-Al_{0.4}Ga_{0.6}As cladding layer 10 having a thickness of 0.3 µm in the area over the protective layer 8, an Al_{0.1}Ga_{0.9}As active layer 11 with a thickness of 0.08 µm, an n-Al_{0.4}Ga_{0.6}As cladding layer 12 with a thickness of 1.2 µm, and an n-GaAs contact layer 13 with a thickness of 1.5 µm are successively formed by LPE. Then, an n-side electrode 16 and a p-side electrode 17 are formed on the top surface of the contact layer 13 and the bottom face of the substrate 1, respectively. In the semiconductor laser array device produced in this way, because the p-GaAs substrate 1 is electrically connected to the p-Al_{0.4}Ga_{0.6}As cladding layer 10 by the grooves 9, the Al_{0.1}Ga_{0.9}As active layer 11 functions as a laser oscillation operating area 14. This semiconductor laser array device is disadvantageous in that the grooves 9 are not completely filled with the p-Al_{0.4}Ga_{0.6}As cladding layer 10, resulting in a bend of the AlGaAs active layer 11, as shown in Figure 3 which causes a weakness of the optical coupling between the adjacent waveguides. Thus, laser oscillation occurs in the individual waveguide, which causes difficulties in attaining laser oscillation in a synchronous phase mode.

To overcome these problems, semiconductor laser array devices with current-confining structures, in which grooves such as those mentioned above are formed with a certain pitch over the entire surface of a substrate, resulting in an even, flat active layer, have been proposed.

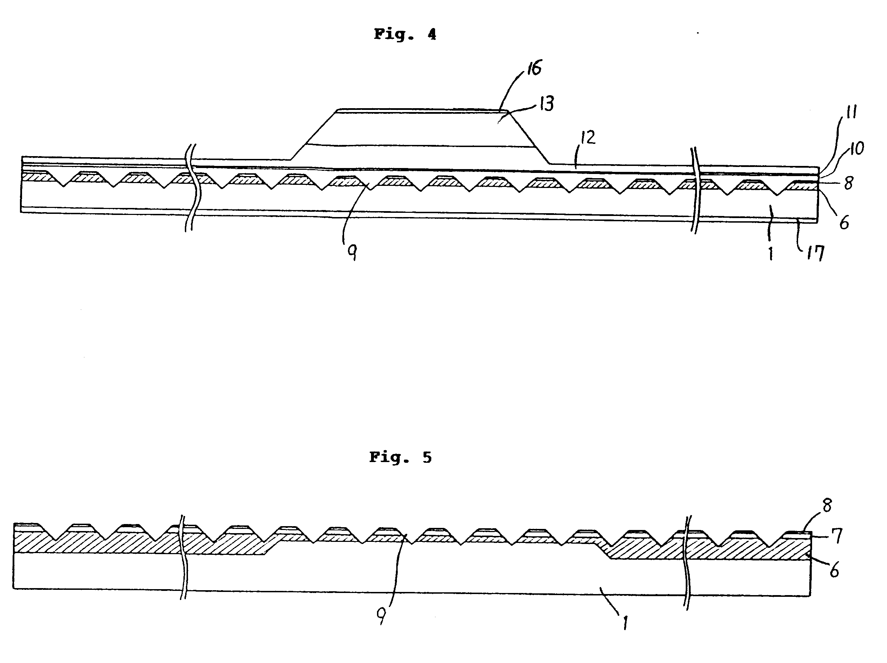

Figure 4 shows one of the current-confining structures, a ridge-guide structure, in which grooves 9 are disposed over the entire surface of the p-GaAs substrate 1, and accordingly they are uniformly filled with a p-Al_{0.4}Ga_{0.6}As cladding layer 10. This structure is disadvantageous in that because the p-GaAs substrate 1 is electrically connected to the p-Al_{0.4}Ga_{0.6}As cladding layer 10 by the grooves 9, if the ridges were not formed with fair accuracy, current injected leaks in the lateral direction, resulting in laser oscillation from other than the desired waveguides. Even if such laser oscillation does not arise, the current leakage will have an influence on the desired laser oscillation mode.

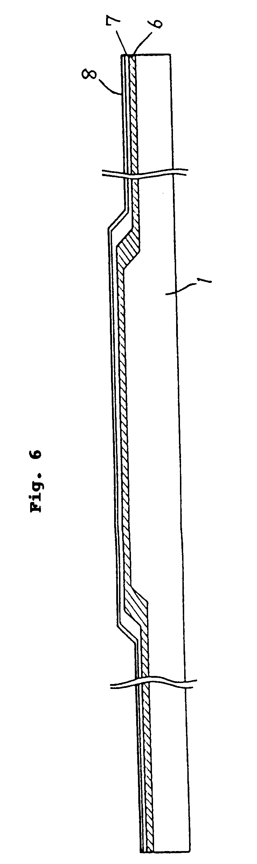

Figure 5 shows another current-confining structure, in which a p-GaAs substrate 1 is formed into a mesa with a height of 1 µm that contributes to laser oscillation. An n-Al_{0.1}Ga_{0.9}As current blocking layer 6 is formed on the substrate 1 in such a way that the mesa-side surface of the substrate 1 becomes flat. On the current blocking layer 6, an n-Al_{0.1}Ga_{0.9}As layer 7 that protects the blocking layer 6 from being etched back in the succeeding step, and an n-GaAs protective layer 8 that protects the n-Al_{0.1}Ga_{0.9}As layer 7 are successively formed, followed by forming grooves 9 in the entire surface of the protective layer 8 in a manner to reach only the mesa of the substrate 1 through the current blocking layer 6. Because the grooves 9 are formed over the entire surface of the grown layer, the active layer that is formed in the succeeding step does not bend so that stabilized oscillation operation can be attained. However, in practice, it is extremely difficult to grow a flat n-A1_{0.1}Ga_{0.9}As current blocking layer 6 with a thickness of 0.5µm, a flat n-A1_{0.1}Ga_{0.9}As protecting layer 7 with a thickness of 0.2µm, and a flat n-GaAs protective layer 8 with a thickness of 0.1µm on the substrate 1 in that order. Especially, the width of the mesa of the substrate 1 must be enlarged with an increase in the number of waveguides, resulting in steps at the portions of these grown layers that correspond to the edges of the mesa, as shown in Figure 6.

The semiconductor laser array device of this invention, which aims to overcome the above-discussed and numerous other disadvantages and deficiencies of the prior art, comprises a substrate with a plurality of first grooves with a given pitch formed on the entire surface of said substrate; a current blocking layer with a conductivity type that is different from that of said substrate and that is disposed on the groove-side surface of said substrate, said current blocking layer having a plurality of second grooves with the same pitch as that of said plurality of first grooves formed on the entire crystal growth surface of said current blocking layer that is opposite to the groove-side surface of said substrate; and a heterostructure multi-layered crystal that is disposed on said current blocking layer, said multi-layered crystal having an active layer for laser oscillation that is sandwiched between different conductive-type grown layers, wherein the position of each of the first grooves is shifted half a pitch from that of each of the second grooves in an area corresponding to a laser oscillation operating area that is created within said active layer, but each of the first grooves is positioned over each of the second grooves in an area on both sides of said laser oscillation operating area corresponding to a non-laser oscillation operating area within said active layer, said second grooves reaching said substrate through said current blocking layer in the area corresponding to said laser oscillation operating area alone, which results in current paths.

In a preferred embodiment, the position of each of the first grooves in the area that corresponds to said laser oscillation operating area is shifted half a pitch from that of each of the first grooves in the area that corresponds to said non-laser oscillation operating area.

In a preferred embodiment, the position of each of the second grooves in the area that corresponds to said laser oscillation operating area is shifted half a pitch from that of each of the second grooves in the area that corresponds to said non-laser oscillation operating area.

Thus, the invention described herein makes possible the objectives of (1) providing a semiconductor laser array device that has an excellent inner confining structure; (2) providing a semiconductor laser array device in which because a plurality of grooves are disposed not only on the entire surface of the substrate but also on the entire surface of the grown layers formed on the substrate, the epitaxial growth conditions under which crystal layers are grown on the substrate with the grooves and on the grown layers with the grooves are uniform over the entire surface of the substrate with the grooves and over the entire surface of the grown layers with the grooves, resulting in an active layer with a flat surface regardless of the number of waveguides; and (3) providing a semiconductor laser array device in which because the grooves of a current-injected area reach the substrate through the current blocking layer in the laser-oscillation operating area alone of the active layer, current can be injected into the laser oscillation-operating area alone, thereby attaining stabilized laser oscillation operation.

By way of example only, a specific embodiment of the present invention will now be described, with reference to the accompanying drawings, in which:-
Figures 1a to 1d are schematic diagrams showing the production process of a semiconductor laser array device of this invention;
Figures 2 and 3 are front sectional views showing conventional semiconductor laser array devices with a VSIS structure;
Figure 4 is a front sectional view showing another conventional semiconductor laser array device with a ridge guide structure;
Figure 5 is a front sectional view showing a portion of another conventional semiconductor laser array device with a ridge guide structure; and
Figure 6 is a schematic diagram showing the part of a production process of the semiconductor laser array device shown in Figure 5.

This invention provides a semiconductor laser array device in which, on a first conductivity-type substrate with a plurality of first grooves disposed over the entire surface of the substrate, a second conductivity-type semiconductor layer with a plurality of second grooves disposed on the entire surface of the semiconductor layer is disposed in such a way that only the second grooves in the area that correspond to the laser oscillation operating area of the active layer reach the substrate, resulting in current paths in the laser oscillation operating area.

### Examples

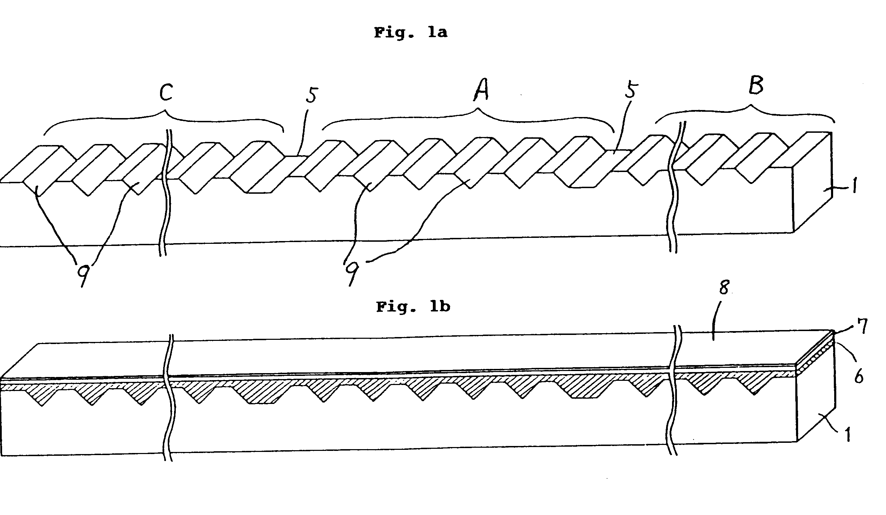

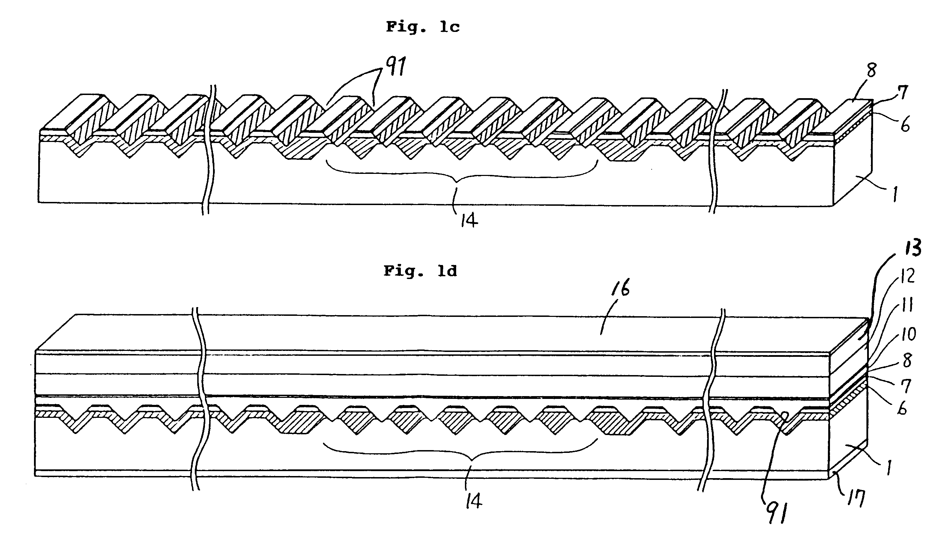

Figures 1a to 1d show the production process of a semiconductor laser array device of this invention. On a p-GaAs substrate 1, mesa portions A, B, and C (namely, a plurality of first grooves 9) are formed by a photolithographic technique and an etching technique, as shown in Figure 1a. The mesa portion A is composed of a plurality of mesas, the number of which is the same as the number of waveguides that contribute to laser oscillation. Each mesa of the mesa portion A has a height of 1 µm, a width of 1 µm at the top thereof, and a pitch of 5 µm. Each mesa of the mesa portions B and C has the same shape and the same pitch as each mesa of the mesa portion A, but the position of each mesa of the mesa portions B and C is shifted half a pitch from that of each mesa of the mesa portion A. Such a shift is made by boundary portions 5 disposed between the mesa portions A and B and between the mesa portions A and C.

Thereafter, as shown in Figure 1b, on the substrate 1 with the mesa portions A, B, and C, an n-Al_{0.1}Ga_{0.9}As current blocking layer 6 having a thickness of 0.5 µm on the mesa portions A, B and C, an n-Al_{0.1}Ga_{0.9}As protective layer 7 having a thickness of 0.2 µm on the mesa portions A, B and C that protects the current blocking layer 6 from being etched back in the succeeding step, and an n-GaAs protective layer 8 having a thickness of 0.1 µm on the mesa portions A, B and C that protects the layer 7 are successively grown by LPE. In this growth step, the rate of crystal growth is high in the grooves 9 between the mesas, but it is suppressed in the area over the mesas, so that the n-Al_{0.1}Ga_{0.9}As current blocking layer 6 can be made flat over the entire surface thereof at the time when the thickness of the current blocking layer 6 has become 0.5 µm.

Then, as shown in Figure 1c, a plurality of second grooves 91 with a pitch of 5 µm, a width of 4 µm, and a depth of 0.9 µm are formed on the entire surface of the protective layer 8 by photolithography and an etching technique in such a way that the grooves 91 corresponding to the mesa portion A are positioned on the top surface of each mesa of the mesa portion A so as to reach the p-GaAs substrate 1 through the current blocking layer 6 and the protective layers 7 and 8, resulting in current paths in the laser oscillation operation area. The other grooves 91 do not reach the p-GaAs substrate 1, resulting in an inner current-confining structure.

Then, as shown in Figure 1d, on the n-GaAs protective layer 8 including the grooves 91, a p-Al_{0.4}Ga_{0.6}As cladding layer 10 having a thickness of 0.3 µm on the flat portion between the grooves 91 is formed by LPE. The surface of this cladding layer 10 becomes flat. Then, on this cladding layer 10, an Al_{0.1}Ga_{0.9}As active layer 11 with a thickness of 0.08 µm, and an n-Al_{0.4}Ga_{0.6}As cladding layer 12 with a thickness of 1.2 µm, by which a double-heterostructure multi-layered crystal for laser oscillation is constituted, are successively formed by LPE. Then, an n-GaAs contact layer 13 with a thickness of 1.5 µm is formed on the n-AlGaAs cladding layer 12 by LPE. Then, an n-side electrode 16 and a p-side electrode 17 are formed on the top surface of the contact layer 13 and the bottom face of the substrate 1, respectively, resulting in a semiconductor laser array device with an inner current-confining structure that attains stabilized laser oscillation.

Although the above-mentioned example discloses a laser array device in which the position of each of the first grooves 9 that are disposed corresponding to the laser oscillation operating area on the p-GaAs substrate 1 is shifted half a pitch from that of each of the first grooves 9 of the substrate 1 corresponding to the non-laser oscillation operating area, this invention is applicable to laser array devices in which the position of each of the second grooves 91 that are disposed corresponding to the laser oscillation operation area on the n-GaAs protective layer 8 is shifted half a pitch from that of each of the second grooves 91 of the n-GaAs protective layer 8 corresponding to the non-laser oscillation operating area.

Moreover, the semiconductor laser array device of the above-mentioned example has only one array region for laser oscillation, but semiconductor laser array devices with two or more array regions can be provided in which the position of each of the grooves that are disposed on the p-GaAs substrate 1 and/or the n-GaAs protective layer 8 is shifted in a limited range from that of each of the others.

Moreover, this invention is, of course, applicable to laser array devices in which the conductivity-type of each of the grown layers and the substrate is different from that of the above-example. Crystal growth methods other than LPE can also be employed, except for the formation of a crystal layer with the flat surface with which grooves are filled.

## Claims

1. A semiconductor laser array device comprising a substrate (1) with a plurality of first grooves (9) with a given pitch formed on the entire surface of said substrate; a current blocking layer (6) with a conductivity type that is different from that of said substrate (1) and that is disposed on the groove-side surface of said substrate, said current blocking layer (6) having a plurality of second grooves (91) with the same pitch as that of said plurality of first grooves formed on the entire crystal growth surface of said current blocking layer that is opposite to the groove-side surface of said substrate (1); and a heterostructure multi-layered crystal (7,8,10,11,12,13) that is disposed on said current blocking layer (6), said multi-layered crystal having an active layer (11) for laser oscillation that is sandwiched between different conductive-type grown layers, wherein the position of each of the first grooves (9) is shifted half a pitch from that of each of the second grooves (91) in an area (A) corresponding to a laser oscillation operating area that is created within said active layer (11), but each of the first grooves (9) is positioned over each of the second grooves (91) in an area (B,C) on both sides of said laser oscillation operating area corresponding to a non-laser oscillation operating area within said active layer (11), said second grooves (91) reaching said substrate (1) through said current blocking layer (6) in the area (A) corresponding to said laser oscillation operating area alone, which results in current paths.

2. A semiconductor laser array device according to claim 1, wherein the position of each of the first grooves (9) in the area (A) that corresponds to said laser oscillation operating area is shifted half a pitch from that of each of the first grooves (9) in the area (B,C) that corresponds to said non-laser oscillation operating area.

3. A semiconductor laser array device according to claim 1, wherein the position of each of the second grooves (91) in the area (A) that corresponds to said laser oscillation operating area is shifted half a pitch from that of each of the second grooves (91) in the area (B,C) that corresponds to said non-laser oscillation operating area.

## Patentansprüche

1. Halbleiterlaseranordnung mit einem Substrat (1) mit einer Anzahl von ersten Nuten (9) mit einer gegebenen Teilung, die auf der gesamten Oberfläche des Substrats gebildet sind; mit einer Stromblockierschicht (6), die einen Leitfähigkeitstypus hat, der sich von der des Substrats (1) unterscheidet und die auf der nutenseitigen Oberfläche des Substrats angeordnet ist, wobei die Stromblockierschicht (6) eine Anzahl von zweiten Nuten (91) mit den gleichen Abständen wie die Anzahl der ersten Nuten aufweist, die auf der gesamten Kristallwachstumsfläche der Stromblockierschicht gebildet sind, die gegenüber der nutenseitigen Oberfläche des Substrats (1) liegt; und mit einem mehrschichtigen Heterostrukturkristall (7, 8, 10, 11, 12, 13), der auf der Stromblockierschicht (6) angeordnet ist, wobei der mehrschichtige Kristall eine aktive Schicht (11) für Laserschwingungen hat, die zwischen aufgewachsenen Schichten von unterschiedlichem Leitfähigkeitstypus liegt, wobei die Lage jeder der ersten Nuten (9) um eine halbe Teilung gegenüber der jeder der zweiten Nuten (91) in einem Gebiet (A) versetzt ist, die einem Laserschwingungs-Operationsgebiet entspricht, das in der aktiven Schicht (11) gebildet ist, wobei aber jede der ersten Nuten (9) über jeder der zweiten Nuten (91) in einem Gebiet (B, C) zu beiden Seiten des Laserschwingungs-Operationsgebiets, das einem Nicht-Laserschwingungs-Operationsgebiet in der aktiven Schicht (11) entspricht, wobei die zweiten Nuten (91) das Substrat (1) durch die Stromblockierschicht (6) in dem Gebiet (A) erreichen, das dem Laserschwingungs-Operationsgebiet allein entspricht, was zu Strompfaden führt.

2. Halbleiterlaseranordnung nach Anspruch 1, wobei die Lage jeder der ersten Nuten (9) in dem Gebiet (A), das dem Laserschwingungs-Operationsgebiet entspricht, eine halbe Teilung gegenüber der für jede der ersten Nuten (9) in dem Gebiet (B, C) versetzt ist, das dem Nicht-Laserschwingungs-Operationsgebiet entspricht.

3. Halbleiterlaseranordnung nach Anspruch 1, wobei die Lage jeder der zweiten Nuten (91) in dem Gebiet (A), das dem Laserschwingungs-Operationsgebiet entspricht, eine halbe Teilung gegenüber der für jede der zweiten Nuten (91) in dem Gebiet (B, C) versetzt ist, das dem Nicht-Laserschwingungs-Operationsgebiet entspricht.

## Revendications

1. Un dispositif de réseau laser à semiconducteur comprenant un substrat (1) dans lequel est ménagée une série de premières rainures (9) selon un pas donné formées sur toute la surface dudit substrat; une couche (6) de blocage de courant dont le type de conductivité est différent de celui dudit substrat (1) et qui est disposée sur la surface dudit substrat située du côté des rainures, ladite couche (6) de blocage de courant comportant une série de deuxièmes rainures (91), au même pas que celui de ladite série de premières rainures, ménagées sur toute la surface de croissance cristalline de ladite couche de blocage de courant qui est opposée à la surface dudit substrat (1) située du côté des rainures; et un cristal à couches multiples à hétérostructure (7, 8, 10, 11, 12, 13) qui est disposé sur ladite couche (6) de blocage de courant, ledit cristal à couches multiples comprenant une couche active (11), prévue pour une oscillation laser, qui est prise en sandwich entre des couches obtenues par croissance à types différents de conductivité, dans lequel la position de chacune des premières rainures (9) est décalée d'un demi pas par rapport à celle de chacune des deuxièmes rainures (91) dans une zone (A) correspondant à une zone de fonctionnement en oscillation laser qui est créée à l'intérieur de ladite couche active (11), mais chacune desdites premières rainures (9) est positionnée au-dessus de chacune desdites deuxièmes rainures (91) dans une zone (B, C) située sur les deux côtés de ladite zone de fonctionnement en oscillation laser, correspondant à une zone ne fonctionnant pas en oscillation laser à l'intérieur de ladite couche active (11), lesdites deuxièmes rainures (91) n'atteignant ledit substrat (1) à travers ladite couche (6) de blocage de courant que dans la zone (A) correspondant à ladite zone fonctionnant en oscillation laser, d'où il résulte des trajets de courant.

2. Un dispositif de réseau laser à semiconducteur selon la revendication 1, dans lequel la position de chacune des premières rainures (9) dans la zone (A) qui correspond à ladite zone fonctionnant en oscillation laser est décalée d'un demi pas par rapport à celle de chacune des premières rainures (9) de la zone (B, C) qui correspond à ladite zone ne fonctionnant pas en oscillation laser.

3. Un dispositif de réseau laser à semiconducteur selon la revendication 1, dans lequel la position de chacune des deuxièmes rainures (91) dans la zone (A) qui correspond à ladite zone fonctionnant en oscillation laser est décalée d'un demi pas par rapport à celle de chacune des deuxièmes rainures (91) de la zone (a, c) qui correspond à ladite zone ne fonctionnant pas en oscillation laser.
